# EUROPEAN PATENT APPLICATION

(11) **EP 1 655 786 A2**
(43) Date of publication of application: **10.05.2006**
(21) Application number: 05254035.8
(22) Date of filing: 28.06.2005
(51) Int. Cl.: H01L 33/00

(54) **Method of forming electrode for compound semiconductor device**

(30) Priority: 08.11.2004 KR 2004090351
(71) Applicant: Samsung Electro-mechanics Co., Ltd, Suwon-si, Gyeonggi-do (KR)
(72) Inventor: Kwak, Tae-yeon, 301-1101 Sinyeongtong Hyundai Apt., Hwaseing-si Gyeonggi-do (KR); Song, June-o, Dept. of Materials Science and Eng., Seoul (KR); Seong, Tae-yeon, Dept. of Materials Science & Eng, Buk-gu Gwangju-si (KR)
(74) Representative: Kyle, Diana

(57) **Abstract**

Provided is a method of forming an electrode for a compound semiconductor device. The method includes forming a first electrode layer (110) on a p-type compound semiconductor layer (100), and performing plasma treatment on the first electrode layer in an oxygen (O₂)- containing atmosphere.

## Description

The present invention relates to a method of forming an electrode for a compound semiconductor device.

The formation of a high quality ohmic contact between a semiconductor layer and an electrode is of considerable importance in realizing optical devices such as light emitting diodes (LEDs) and laser diodes (LDs) that use compound semiconductor devices.

In a gallium nitride (GaN)-based semiconductor device, a nickel (Ni)-based metallic thin film structure, e.g., a Ni/gold (Au) transparent metallic thin film, can be used as an electrode on a p-GaN semiconductor layer (See U. S. Patent Nos. 5,877,558 and 6,008,539).

It is known that the Ni/Au metallic thin film can be annealed in an oxygen (O₂) atmosphere to form an ohmic contact with low specific contact resistivity of about 10⁻⁴ to 10⁻³ Ω cm². Due to the low specific contact resistivity, annealing the Ni/Au layer at a temperature of 500 to 600°C in an oxygen (O₂) atmosphere leads to the formation of a nickel oxide (NiO) on the island-like Au thin films, thereby reducing a Schottky barrier height at the p-GaN/Ni interface. Thus, holes that are majority carriers can be easily injected into the surface of GaN, increasing the effective carrier concentration near the GaN surface.

However, depositing the Ni/Au layer on the p-GaN semiconductor layer and annealing the same in the O₂ atmosphere will cause voids in the Ni/Au layer. The voids increase the operating voltage of an LD or decrease the output power of an LED.

The present invention provides a method of forming an electrode for a compound semiconductor device, which can suppress void formation during the formation of the electrode.

According to an aspect of the present invention, there is provided a method of forming an electrode for a compound semiconductor device. The method includes forming a first electrode layer on a p-type compound semiconductor layer, and performing plasma treatment on the first electrode layer in an oxygen (O₂)-containing atmosphere.

The method may further include forming a second electrode layer on the first electrode layer. At least a portion of the first electrode layer may be oxidized or made to contain O₂, by performing the plasma treatment in the O₂-containing atmosphere.

The method may further include annealing the first electrode layer in an atmosphere containing at least one of nitrogen (N₂) and O₂, or in a vacuum atmosphere. The p-type compound semiconductor layer may include a p-type gallium nitride (GaN) semiconductor layer.

The first electrode layer may be made from at least one selected from the group consisting of nickel (Ni), Ni-alloy, zinc (Zn), Zn-alloy, magnesium (Mg), Mg-alloy, ruthenium (Ru), Ru-alloy, and lanthanum (La)-alloy. Alternatively, the first electrode layer may be made from a transparent conducting oxide such as indium tin oxide (ITO) or zinc oxide (ZnO). It may be formed to less than 5 µm using electron-beam (e-beam) deposition or sputtering.

The second electrode layer may be made from at least one selected from the group consisting of gold (Au), palladium (Pd), platinum (Pt), ruthenium (Ru), and a transparent conducting oxide. Alternatively, it can be made from a highly reflective material such as silver (Ag), aluminum (Al), or rhodium (Rh).

The above and other features and advantages of the present invention will become more apparent by describing in detail exemplary embodiments thereof with reference to the attached drawings in which:

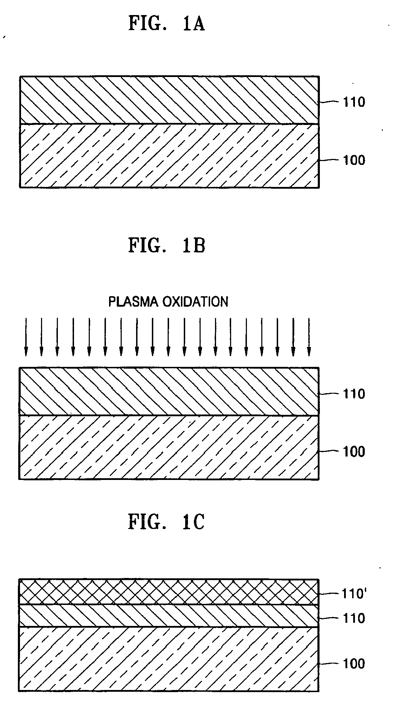

FIGS. 1A-1 E are cross-sectional views for explaining a method of forming an electrode for a compound semiconductor device according to an embodiment of the present invention;

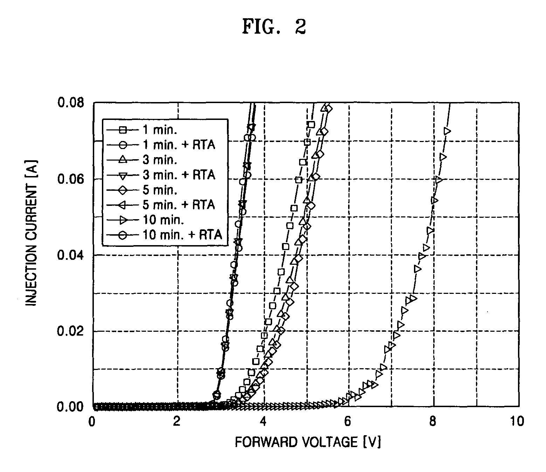

FIG. 2 illustrates current-voltage (I-V) characteristics of a light emitting diode (LED) measured before and after performing rapid thermal annealing (RTA) in a nitrogen (N₂) atmosphere of the structure obtained after performing plasma oxidation of a nickel (Ni) layer (first electrode layer) and depositing a gold (Au) layer (second electrode layer) on the Ni layer; and

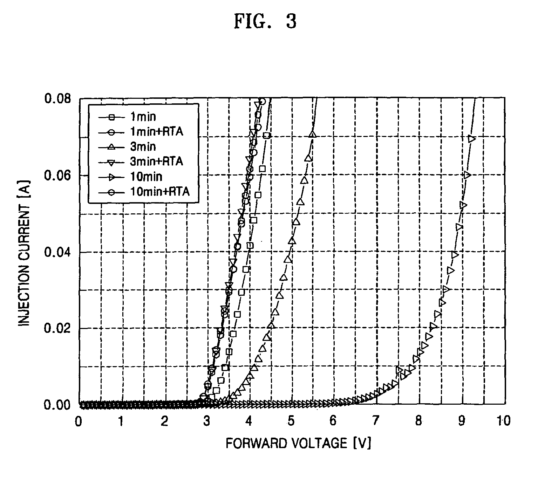

FIG. 3 illustrates I-V characteristics of an LED measured before and after performing RTA in a N₂ ambient of the structure obtained after performing plasma oxidation on a ruthenium (Ru) layer (first electrode layer) and depositing a highly reflective silver (Ag) layer (second electrode layer) on the Ru layer.

Hereinafter, the present invention will be described in detail by explaining preferred embodiments of the invention with reference to the attached drawings. Like reference numerals denote like elements throughout the drawings.

Referring to FIG. 1A, a first electrode layer 110 is formed on a p-type compound semiconductor layer 100. The p-type compound semiconductor layer 100 may be made from p-type gallium nitride (p-GaN). Here, the p-type compound semiconductor layer 100 may be a p-cladding layer in a light emitting device including an n-cladding layer, a p-cladding layer, and a light-emitting layer sandwiched between the n- and p- cladding layers. The first electrode layer 110 may be an ohmic contact layer formed on the p-cladding layer.

The first electrode layer 110 is formed to less than 5 µm using electron-beam (e-beam) deposition and sputtering. The first electrode layer 110 is made from at least one selected from the group consisting of nickel (Ni), Ni-alloy, zinc (Zn), Zn-alloy, magnesium (Mg), Mg-alloy, ruthenium (Ru), Ru-alloy, and lanthanum (La)-alloy. Alternatively, the first electrode layer 110 may be made from a transparent conducting oxide such as indium tin oxide (ITO) or zinc oxide (ZnO).

Referring to FIG. 1 B, plasma oxidation is performed on the first electrode layer 110 overlying the p-type compound semiconductor layer 100, in an oxygen (O₂) atmosphere. Referring to FIG. 1C, the plasma oxidation forms an oxide layer 110' in an upper portion of the first electrode layer 110. Alternatively, an O₂-containing layer may also be formed in the upper portion of the first electrode layer 110 by the plasma oxidation.

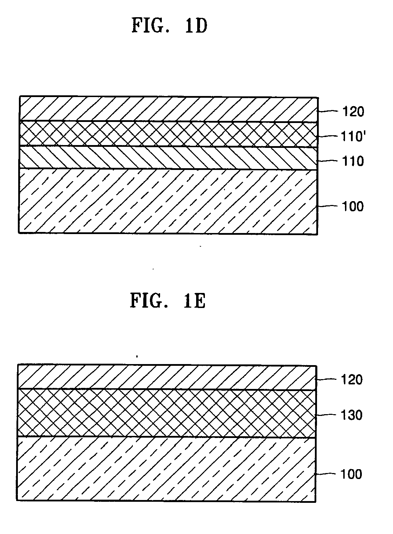

Subsequently, referring to FIG. 1D, a second electrode layer 120 is formed on the oxide layer 110' or the O₂-containing layer using e-beam deposition or sputtering. The second electrode layer 120 is made from at least one selected from the group consisting of gold (Au), palladium (Pd), platinum (Pt), ruthenium (Ru), and transparent conducting oxide such as ITO or ZnO. Alternatively, the second electrode layer 120 can be made from a highly reflective material such as silver (Ag), aluminum (Al), or rhodium (Rh).

Referring to FIG. 1 E, when rapid thermal annealing (RTA) is performed on the resulting structure shown in FiG. 1D, in an atmosphere containing either or both nitrogen (N₂) and O₂, or in a vacuum atmosphere, O₂ diffuses from the oxide layer 110' or the O₂-containing layer into the first electrode layer 110, forming a fully oxidized first electrode layer 130 on the p-type compound semiconductor layer 100. Since the oxidation of the first electrode layer 110 occurs by diffusion rather than by external O₂ injection, voids do not form. While it is described above that the plasma oxidation forms the oxide layer 110' or the O₂-containing layer in the upper portion of the first electrode layer 110, the first electrode layer 110 may be fully oxidized, or the O₂ may be contained in the entire first electrode layer 110.

FIG. 2 illustrates current-voltage (I-V) characteristics of a light emitting diode (LED) measured before and after performing RTA in a nitrogen (N₂) ambient of the structure obtained after performing plasma oxidation on a Ni layer (first electrode layer) and depositing an Au layer (second electrode layer) on the Ni layer. The Ni layer was subjected to plasma oxidation for 1, 3, 5, and 10 minutes.

As is evident from FIG. 2, the forward voltage increases as the plasma oxidation time increases, which means that the Ni layer becomes oxidized over time. However, when RTA is performed in the N₂ atmosphere after depositing the Au layer on the Ni layer, and then the Ni layer combines with O₂ to form nickel oxide (NiO), the forward voltage rapidly decreases.

FIG. 3 illustrates I-V characteristics of an LED measured before and after performing RTA in a N₂ ambient of the structure obtained after performing plasma oxidation on a Ru layer (first electrode layer) and depositing a highly reflective Ag layer (second electrode layer) on the Ru layer. The Ru layer was subjected to plasma oxidation for 1, 3, 5, and 10 minutes.

As is evident from FIG. 3, the forward voltage increases as the plasma oxidation time increases. This means that the Ru layer becomes oxidized over time. However, after RTA is performed in the N₂ atmosphere after depositing the Ag layer on the Au layer, and then the Ru layer combines with O₂ to form ruthenium oxide (RuO), the forward voltage rapidly decreases.

As described above, the method of forming an electrode for a compound semiconductor device according to the present invention prevents void formation within the electrode, thereby decreasing the operating voltage of a laser diode (LD) or increasing the output power of an LED.

While the present invention has been particularly shown and described with reference to exemplary embodiments thereof, it will be understood by those of ordinary skill in the art that various changes in form and details may be made therein without departing from the spirit and scope of the present invention as defined by the following claims. For example, while it is described above that the first and second electrode layers are formed on the p-type compound semiconductor layer, additional electrode layers may be formed on the second electrode layer. Furthermore, a single electrode layer formed on the p-type compound semiconductor layer may be subjected to plasma treatment, or the plasma-treated electrode layer may be annealed in order to form an electrode.

## Claims

1. A method of forming an electrode for a compound semiconductor device, the method comprising:
forming a first electrode layer on a p-type compound semiconductor layer; and
performing plasma treatment on the first electrode layer in an oxygen (O₂)-containing atmosphere.

2. The method according to claim 1, further comprising forming a second electrode layer on the first electrode layer.

3. The method according to claim 1 or 2, wherein at least a portion of the first electrode layer is oxidized or made to contain O₂ by performing the plasma treatment in the O₂-containing atmosphere.

4. The method according to any of claims 1 to 3, further comprising annealing the first electrode layer in an atmosphere containing at least one of nitrogen (N₂) and O₂, or in a vacuum atmosphere.

5. The method according to any of claims 1 to 4, wherein the p-type compound semiconductor layer includes a p-type gallium nitride (GaN) semiconductor layer.

6. The method according to any of claims 1 to 5, wherein the first electrode layer is made from at least one selected from nickel (Ni), Ni-alloy, zinc (Zn), Zn-alloy, magnesium (Mg), Mg-alloy, ruthenium (Ru), Ru-alloy, and lanthanum (La)-alloy.

7. The method according to any of claims 1 to 5, wherein the first electrode layer is made from a transparent conducting oxide.

8. The method according to claim 7, wherein the transparent conducting oxide is indium tin oxide (ITO) or zinc oxide (ZnO).

9. The method according to any of claims 1 to 8, wherein the first electrode layer is formed using electron-beam (e-beam) deposition or sputtering.

10. The method according to any of claims 1 to 9, wherein the first electrode layer is formed to less than 5 µm.

11. The method according to any of claims 2 to 10, wherein the second electrode layer is made from at least one selected from gold (Au), palladium (Pd), platinum (Pt), ruthenium (Ru), and a transparent conducting oxide.

12. The method according to claim 11, wherein the transparent conducting oxide is ITO or ZnO.

13. The method according to any of claims 2 to 12, wherein the second electrode layer is made from a highly reflective material.

14. The method according to claim 13, wherein the second electrode layer is made from at least one selected from silver (Ag), aluminum (Al), and rhodium (Rh).

15. The method according to any of claims 2 to 14, wherein the second electrode layer is formed using electron-beam (e-beam) deposition or sputtering.
